# EUROPEAN PATENT APPLICATION

(11) **EP 4 704 269 A1**
(43) Date of publication of application: **04.03.2026**
(21) Application number: 24797201.1
(22) Date of filing: 26.04.2024
(51) Int. Cl.: H01S 5/183

(54) **SINGLE PHOTON SOURCE DEVICE**

(30) Priority: 28.04.2023 JP 2023074485; 27.09.2023 JP 2023165861
(71) Applicant: INSTITUTE OF SCIENCE TOKYO, Tokyo 152-8550 (JP)
(72) Inventor: NAKAGAWA Shigeru, Tokyo 152-8550 (JP)
(74) Representative: Meissner Bolte Nürnberg
(86) International application number: PCT/JP2024/016526
(87) International publication number: WO 2024/225458

(57) **Abstract**

A single photon source device includes a first reflecting mirror, a second reflecting mirror, and a resonator disposed between the first reflecting mirror and the second reflecting mirror. The resonator includes a stacked structure including a quantum dot that generates a photon corresponding to an electron and a hole injected, an electrode from which an electron or a hole is injected into the quantum dot, and a contact layer provided between the stacked structure and the electrode.

## Description

### TECHNICAL FIELD

The present invention relates to a single photon source device.

### BACKGROUND ART

Conventionally, a VCSEL (Vertical Cavity Surface Emitting Laser) has been known as a semiconductor laser using a vertical resonator. For example, the VCSELs described in Patent Literatures 1 to 3 each have a structure in which an active layer is sandwiched between two reflecting mirrors, and contact layers, through which electrons and holes are injected, are inserted between the active layer and the reflecting mirrors. In these VCSELs, electrons and holes are injected into the active layer through the contact layers, and light is generated in the active layer and emitted through a reflecting mirror. The reflecting mirrors are constituted by DBR (Distributed Bragg Reflector) mirrors formed by stacked semiconductor layers.

### RELATED-ART LITERATURE

### PATENT LITERATURE

Patent Literature 1: Specification of U.S. Patent No.6653158
Patent Literature 2: Specification of U.S. Patent No.6687281
Patent Literature 3: Specification of U.S. Patent No.6714573

### SUMMARY OF INVENTION

### TECHNICAL PROBLEM

The present invention has a purpose of generating single photons from a vertical resonator and applies a VCSEL structure with contact layers provided between reflecting mirrors and an active layer. The active layer includes a tiny quantum dot. Meanwhile, the inventor has recognized the following problem. In order to inject electrons and holes into the active layer through the contact layers containing semiconductors, the contact layers need to be doped with impurity ions to lower the resistance of the contact layers. However, these impurity ions absorb photons, and there has been room for more efficient extraction of photons generated in the active layer.

The present invention has been made in view of such a situation, and an illustrative purpose thereof is to provide a single photon source device that can efficiently emit single photons.

### SOLUTION TO PROBLEM

A single photon source device according to one embodiment of the present invention includes a first reflecting mirror, a second reflecting mirror, and a resonator disposed between the first reflecting mirror and the second reflecting mirror. The resonator includes a stacked structure including a quantum dot that generates a photon corresponding to an electron and a hole injected, an electrode from which an electron or a hole is injected into the quantum dot, and a contact layer provided between the stacked structure and the electrode.

According to this embodiment, since a path for electrons or holes flowing from the electrode to the quantum dot does not include a reflecting mirror, the resistance of the path can be made lower without doping impurity ions into the reflecting mirrors and the like. As a result, absorption of generated photons by impurity ions can be suppressed, and the photons can be efficiently emitted.

Optional combination of the aforementioned constituting elements, and methods, devices, systems, and the like among which expressions in the present invention are transformed are also effective as embodiments of the present invention.

### ADVANTAGEOUS EFFECTS OF INVENTION

The present invention provides a single photon source device that can efficiently emit single photons.

### BRIEF DESCRIPTION OF DRAWINGS

[Fig. 1] Fig. 1 is a sectional view of a single photon source device according to a first embodiment.
[Fig. 2] Fig. 2 is a diagram that shows a positional relationship between a standing wave of a photon generated by a quantum dot and each component of a resonator.
[Fig. 3] Fig. 3 is a sectional view of a resonator according to a second embodiment.
[Fig. 4] Fig. 4 is a diagram for illustrating a process by which a photon is generated by combination of an electron and a hole in the same embodiment.

### DESCRIPTION OF EMBODIMENTS

### Embodiments

In the following, modes for carrying out the present invention will be described in detail with reference to the drawings. In the description of drawings, like reference characters denote like elements, and repetitive description will be omitted as appropriate.

### First Embodiment

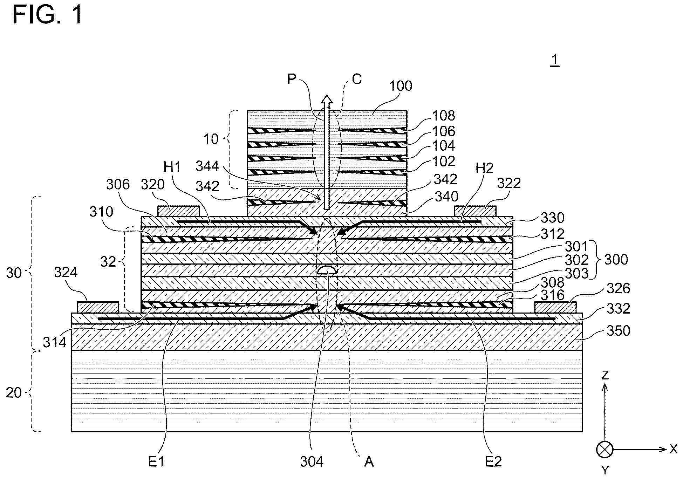

Fig. 1 is a sectional view of a single photon source device 1 according to the first embodiment. The single photon source device 1 generates a photon corresponding to an electron and a hole injected thereinto and emits the photon to the outside. The single photon source device 1 according to the present embodiment includes a first reflecting mirror 10, a second reflecting mirror 20, and a resonator 30.

The single photon source device 1 according to the first embodiment is constituted by various semiconductor layers stacked. In the present specification, the axis along the direction in which the semiconductor layers are stacked is designated as the Z-axis, the axis perpendicular to the Z-axis is designated as the X-axis, and the axis perpendicular to the Z-axis and the X-axis is designated as the Y-axis. The positive direction of the Z-axis is defined as the upward direction, the negative direction of the Z-axis is defined as the downward direction, the positive direction of the X-axis is defined as the right direction, and the negative direction of the X-axis is defined as the left direction.

The resonator 30 is disposed between the first reflecting mirror 10 and the second reflecting mirror 20. The resonator 30 is configured to generate a photon corresponding to an electron and a hole injected thereinto and emit the photon to the first reflecting mirror 10. The resonator 30 according to the present embodiment mainly includes a stacked structure 32, an upper contact layer 330, a lower contact layer 332, positive electrodes 320 and 322, negative electrodes 324 and 326, spacer layers 340 and 350, and an oxide lens layer 342. Although the present embodiment describes an example in which the number of negative electrodes is two, the number of negative electrodes may be one or may be three or more. Also, although the present embodiment describes an example in which the number of positive electrodes is two, the number of positive electrodes may be one or may be three or more.

The stacked structure 32 is constituted by stacked semiconductor layers. The stacked structure 32 includes an active layer 300, a hole guide layer 306, an electron guide layer 308, and oxide confinement layers 310, 312, 314, and 316.

The active layer 300 includes an upper layer 301, a buffer layer 302, and a lower layer 303. The upper layer 301, buffer layer 302, and lower layer 303 may be made of, for example, a semiconductor such as GaAs. The buffer layer 302 is provided inside the active layer 300 such as to be vertically sandwiched between the upper layer 301 and the lower layer 303. Inside the buffer layer 302, a quantum dot 304 is formed.

A quantum dot is an extremely small (nano-sized) semiconductor particle with a diameter of about 2 to 10 nm. An electron in a quantum dot has an energy range. The concepts of the energy levels, band gap, conduction band, and valence band can also be applied to a quantum dot; however, there is one major difference between a quantum dot and an ordinary semiconductor. When the particle size of a semiconductor particle is reduced to nano-size, it approaches the size of the exciton Bohr radius, and the electron energy levels become discrete rather than continuous. This state is called the quantum confinement effect, and a semiconductor material ceases to be bulk and instead becomes a quantum dot. This state significantly affects the absorption and light emission by the semiconductor material.

As in a bulk semiconductor material, in a quantum dot, an electron tends to move from end to end of the band gap. However, in a quantum dot, the size of the band gap can be controlled simply by changing the particle size of the quantum dot. The emission wavelength of a quantum dot depends on the band gap and hence can be adjusted very precisely.

Because a quantum dot is zero-dimensional, the density of states thereof is much sharper (delta-functional) than that of a higher dimensional structure. Also, since a quantum dot is small in size, electrons do not need to travel long distances as in the case of a large particle. This allows electronic devices using quantum dots to operate faster. Utilizing such electronic properties, quantum dots are applied to, for example, transistors, solar cells, ultrafast all-optical switches and logic gates, and quantum computers.

The quantum dot 304 according to the present embodiment generates a photon corresponding to an electron and a hole injected thereinto. The photon is generated in a photon generation region A. The quantum dot 304 may be made of, for example, InAs or InGaAs. The quantum dot 304 may have a diameter of about 10 nm, for example.

The quantum dot 304 generates a photon corresponding to an electron and a hole injected thereinto. Although the buffer layer 302 including the quantum dot 304 generates photons with various wavelengths, the resonator 30 according to the present embodiment is configured to generate single photons with a specific wavelength. In specific, the resonator 30 is configured such that the length in the Z-axis direction thereof is an integer multiple of the specific wavelength. More specifically, the resonator 30 is configured such that the distance from the lower surface of the spacer layer 350 to the upper surface of the spacer layer 340 is an integer multiple of the specific wavelength.

The hole guide layer 306 is provided on the upper surface of the upper layer 301, and the electron guide layer 308 is provided on the lower surface of the lower layer 303. Each of the hole guide layer 306 and the electron guide layer 308 may be made of, for example, a semiconductor such as GaAs.

The upper contact layer 330 is provided between the stacked structure 32 and the positive electrodes 320 and 322. The upper contact layer 330 according to the present embodiment is provided between the first reflecting mirror 10 and the stacked structure 32. The upper contact layer 330 is connected to one end surface (specifically, the upper surface) in a stacking direction of the stacked structure 32 (specifically, the hole guide layer 306). The upper contact layer 330 has a lower resistance than the stacked structure 32. The upper contact layer 330 may be made of various semiconductors doped with impurity ions. For example, the upper contact layer 330 may be made of GaAs doped with C. The thickness of the upper contact layer 330 may be, for example, about 50 to 100 nm.

The positive electrodes 320 and 322 are provided on the upper contact layer 330. The positive electrodes 320 and 322 are provided from which holes are injected into the quantum dot 304 in the active layer 300. The positive electrode 320 is provided at a position that is shifted in the negative direction of the X-axis with respect to the quantum dot 304 when viewed in plan view in the Z-axis direction. The positive electrode 322 is provided at a position that is shifted in the positive direction of the X-axis with respect to the quantum dot 304 when viewed in plan view in the Z-axis direction.

The upper contact layer 330 has a lower resistance than the first reflecting mirror 10, the spacer layer 340, and the stacked structure 32 (specifically, the active layer 300, for example). The holes injected from the positive electrodes 320 and 322 flow to the quantum dot 304 without passing through the first reflecting mirror 10. Accordingly, with the single photon source device 1 according to the present embodiment, the holes do not need to flow through the first reflecting mirror 10 and the spacer layer 340, and hence, there is no need to dope impurity ions into the first reflecting mirror 10 and the spacer layer 340 to lower the resistance of the first reflecting mirror 10. Therefore, absorption of the generated photons by the first reflecting mirror 10 can be suppressed.

The lower contact layer 332 is provided between the stacked structure 32 and the negative electrodes 324 and 326. The lower contact layer 332 according to the present embodiment is provided between the second reflecting mirror 20 and the stacked structure 32. The lower contact layer 332 is connected to the other end surface (specifically, the lower surface) in the stacking direction of the stacked structure 32 (specifically, the electron guide layer 308). The lower contact layer 332 has a lower resistance than the stacked structure 32. The lower contact layer 332 may be made of various semiconductors doped with impurity ions.
For example, the lower contact layer 332 may be made of GaAs doped with Si. The thickness of the lower contact layer 332 may be, for example, about 50 to 100 nm.

Although the present embodiment describes an example in which the positive electrodes are provided on the upper surface side of the active layer 300 and the negative electrodes are provided on the lower surface side of the active layer 300, the arrangement of the positive electrodes and the negative electrodes is not limited thereto. For example, the positive electrodes may be provided on the upper surface side of the active layer 300, and the negative electrodes may be provided on the lower surface side of the active layer 300.

The negative electrodes 324 and 326 are provided on the lower contact layer 332. The negative electrodes 324 and 326 are provided from which electrons are injected into the quantum dot 304 in the active layer 300.

The lower contact layer 332 has a lower resistance than the second reflecting mirror 20, the spacer layer 350, and the stacked structure 32 (specifically, the active layer 300, for example). The electrons injected from the negative electrodes 324 and 326 flow to the quantum dot 304 without passing through the second reflecting mirror 20. Accordingly, with the single photon source device 1 according to the present embodiment, the electrons do not need to flow through the second reflecting mirror 20 and the spacer layer 350, and hence, there is no need to dope impurity ions into the second reflecting mirror 20 to lower the resistance of the second reflecting mirror 20. Therefore, absorption of the generated photons by the second reflecting mirror 20 and the spacer layer 350 can be suppressed.

The oxide confinement layers 310, 312, 314, and 316 are provided to form paths for the electrons and holes flowing between the positive electrodes 320 and 322 and the negative electrodes 324 and 326 inside the resonator 30 (specifically, the stacked structure 32, upper contact layer 330, and lower contact layer 332). The oxide confinement layers 310, 312, 314, and 316 are constituted by high-resistivity layers having higher resistivity than the stacked structure 32 and, specifically, the layers may be made of various oxides, such as aluminum oxide. In specific, the oxide confinement layers 310, 312, 314, and 316 containing aluminum oxide may be prepared by forming AlAs layers in the resonator 30 and then exposing the AlAs layers to water vapor so as to oxidize Al. The thickness of each of the oxide confinement layers 310, 312, 314, and 316 may be, for example, about 10 to 20 nm.

The oxide confinement layer 310 is provided to form a path for a hole flowing from the positive electrode 320 to the quantum dot 304. In specific, the oxide confinement layer 310 is positioned above the quantum dot 304 and is formed to extend in the direction from the left end of the hole guide layer 306 toward the quantum dot 304 (specifically, in the right direction) when viewed in plan view in the Z-axis direction. This suppresses the flow of a hole H1 to the negative electrode 324, so that the hole H1 flows in the direction toward the quantum dot 304 (e.g., in the direction indicated by the arrow shown in Fig. 1). As a result, the hole H1 can be efficiently injected into the quantum dot 304.

The oxide confinement layer 312 is provided to form a path for a hole flowing from the positive electrode 322 to the quantum dot 304. In specific, the oxide confinement layer 312 is positioned above the quantum dot 304 and is formed to extend in the direction from the right end of the hole guide layer 306 toward the quantum dot 304 (specifically, in the left direction) when viewed in plan view in the Z-axis direction. This suppresses the flow of a hole H2 to the negative electrode 326, so that the hole H2 flows in the direction toward the quantum dot 304 (e.g., in the direction indicated by the arrow shown in Fig. 1). As a result, the hole H2 can be efficiently injected into the quantum dot 304.

The oxide confinement layer 314 is provided to form a path for an electron flowing from the negative electrode 324 to the quantum dot 304. In specific, the oxide confinement layer 314 is positioned below the quantum dot 304 and is formed to extend in the direction from the left end of the electron guide layer 308 toward the quantum dot 304 (specifically, in the right direction) when viewed in plan view in the Z-axis direction. This suppresses the flow of an electron E1 to the positive electrode 320, so that the electron E1 flows in the direction toward the quantum dot 304 (e.g., in the direction indicated by the arrow shown in Fig. 1). As a result, the electron E1 can be efficiently injected into the quantum dot 304.

The oxide confinement layer 316 is provided to form a path for an electron flowing from the negative electrode 326 to the quantum dot 304. In specific, the oxide confinement layer 316 is positioned below the quantum dot 304 and is formed to extend in the direction from the right end of the electron guide layer 308 toward the quantum dot 304 (specifically, in the left direction) when viewed in plan view in the Z-axis direction. This suppresses the flow of an electron E2 to the positive electrode 322, so that the electron E2 flows in the direction toward the quantum dot 304 (e.g., in the direction indicated by the arrow shown in Fig. 1). As a result, the electron E2 can be efficiently injected into the quantum dot 304.

The present embodiment describes an example in which the oxide confinement layers 310, 312, 314, and 316 are provided inside the hole guide layer 306 and the electron guide layer 308. The application is not limited thereto, and oxide confinement layers may be provided inside the upper contact layer 330 or the lower contact layer 332. Also, all of the oxide confinement layers 310, 312, 314, and 316 need not be provided, and, for example, only the oxide confinement layers 310 and 312 may be provided.

The spacer layer 350 is provided on the lower surface of the lower contact layer 332. The spacer layer 350 may be made of, for example, a semiconductor such as GaAs. A photon generated by the quantum dot 304 passes through the spacer layer 350 and is emitted to the second reflecting mirror 20.

The spacer layer 340 is provided on the upper surface of the upper contact layer 330. The spacer layer 350 may be made of, for example, a semiconductor such as GaAs. A photon generated by the quantum dot 304 enters through the spacer layer 340 and is emitted to the first reflecting mirror 10.

In the present embodiment, the oxide lens layer 342 is provided inside the spacer layer 340. The oxide lens layer 342 functions as a photon guide layer that directs a photon in the resonator 30 in a predetermined direction.
The oxide lens layer 342 may be constituted by, for example, an oxide layer made of aluminum oxide or the like. For example, the oxide lens layer 342 containing aluminum oxide may be prepared by forming an AlAs layer in the spacer layer 340 and then exposing the AlAs layer to water vapor so as to oxidize Al.

The oxide lens layer 342 includes an opening 344. The opening 344 is formed in the center of the spacer layer 340. The opening 344 is formed such that the diameter thereof decreases from the lower end of the oxide lens layer 342 toward the upper side. This enables a photon P generated in the quantum dot 304 to be collected in the center of the opening 344 inside the resonator 30.

The first reflecting mirror 10 is constituted by a multilayer film, which includes a DBR mirror 100 and oxide lens layers 102, 104, 106, and 108 provided therein. Although Fig. 1 shows the four oxide lens layers 102, 104, 106, and 108, the number of oxide lens layers may be three or less or may be five or more.

The DBR mirror 100 is constituted by a multilayer film in which semiconductor layers with different refractive indexes are alternately stacked. The DBR mirror 100 may have a structure in which GaAs films and AlGaAs films are alternately stacked, for example. The number of semiconductor layers constituting the DBR mirror 100 may be about 80, for example. This allows for a reflectance of about 99.9%, for example.

The oxide lens layers 102, 104, 106, and 108 are arranged in this order in the upward direction and spaced apart from each other. The oxide lens layers 102, 104, 106, and 108 are provided to function as waveguide forming layers, specifically, to form a waveguide C along the Z-axis, through which a photon P passes in the DBR mirror 100. This allows the photon P to be efficiently extracted to the outside.

Also, by providing the oxide lens layers 102, 104, 106, and 108, roughness of the sidewall of the first reflecting mirror 10 can be suppressed. The first reflecting mirror 10 can be fabricated into a desired shape by etching, and providing the oxide lens layers 102, 104, 106, and 108 can suppress the loss of photons caused by residual ions and the like in the first reflecting mirror 10 after the etching.

The second reflecting mirror 20 is constituted by a DBR mirror. The second reflecting mirror 20 may have a structure in which GaAs films and AlAs films are alternately stacked, for example. Also, AlGaAs films may be used instead of AlAs films. The second reflecting mirror 20 may be constituted by, for example, about 80 semiconductor layers. This allows for a reflectance of about 99.9%, for example. The second reflecting mirror 20 is configured to have a higher reflectance than the first reflecting mirror 10. This allows a photon to be extracted from the first reflecting mirror 10 to the outside.

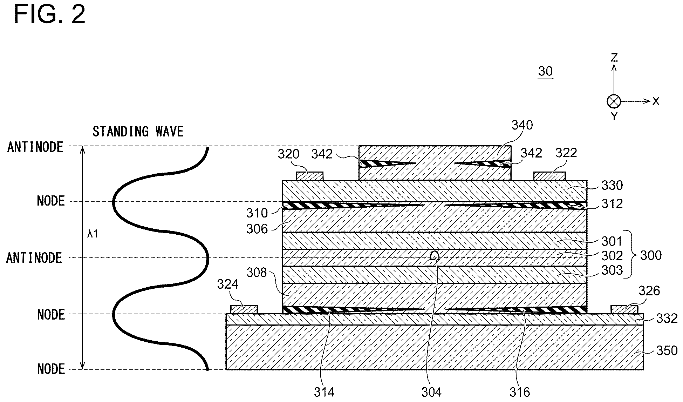

Fig. 2 is a diagram that shows a positional relationship between a standing wave of a photon generated by the quantum dot 304 and each component of the resonator 30. Fig. 2 schematically shows nodes and antinodes of a standing wave of a photon, and the standing wave has the antinodes at the lower surface of the spacer layer 350, the quantum dot 304, and the upper surface of the spacer layer 340. The wavelength of the standing wave is λ1.

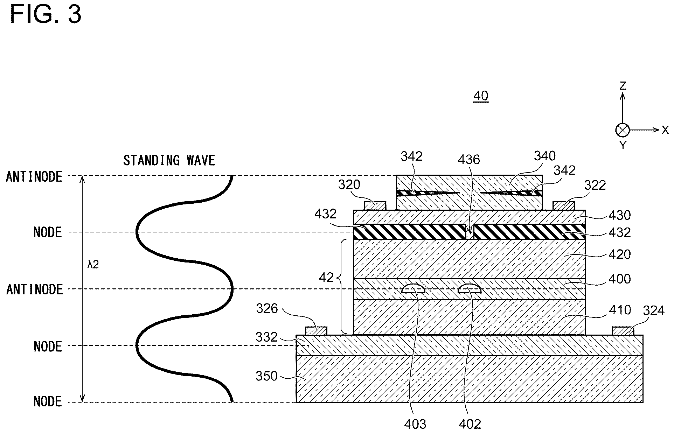

The standing wave shown in Fig. 2 represents |Ep|² when the electric field of the photon is defined as Ep. Each antinode of the standing wave is a position where |Ep|² reaches the maximum value thereof, and each node of the standing wave is a position where |Ep|² reaches the minimum value thereof. The same applies to Fig. 3 described later. In the first reflecting mirror 10, the standing wave is located such that the electric field of the photon attenuates from the lower end toward the upper end of the DBR mirror 100.

The upper contact layer 330 is preferably provided at or near a node of the standing wave. For example, the upper contact layer 330 may be provided such that the entire thickness thereof falls within the range of ±(1/8)λ1 or the range of ±(1/16)λ1 in the Z-axis direction from the node of the standing wave. The thickness of the upper contact layer 330 may be, for example, (1/4)λ1 or less or may be (1/8)λ1 or less.

The upper contact layer 330 according to the present embodiment contains impurity ions, which absorb photons. By providing the upper contact layer 330 at or near a node of the standing wave, the absorption of photons can be suppressed, and photons can be generated more efficiently and extracted to the outside. Since the lower contact layer 332 also contains impurity ions, it is preferable that, as with the upper contact layer 330, the lower contact layer 332 is also provided at or near a node of the standing wave of a photon. The thickness of the lower contact layer 332 may be designed in the same manner as the upper contact layer 330.

Each of the oxide confinement layers 310, 312, 314, and 316 is preferably provided at or near a node of the standing wave of a photon. For example, each of the oxide confinement layers 310, 312, 314, and 316 may be provided such that the entire thickness thereof falls within the range of ±(1/8)λ1 or the range of ±(1/16)λ1 in the Z-axis direction from the node of the standing wave. The thickness of each of the oxide confinement layers 310, 312, 314, and 316 may be, for example, (1/4)λ1 or less or may be (1/8)λ1 or less. By providing each of the oxide confinement layers 310, 312, 314, and 316 at or near a node of the standing wave, attenuation (scattering) of photons caused by the oxide confinement layers 310, 312, 314, and 316 can be suppressed.

The oxide lens layer 342 is preferably provided at a different position from the nodes and antinodes of the standing wave of a photon. In specific, the oxide lens layer 342 is preferably provided between a node and an antinode adjacent thereto in the standing wave of a photon. For example, the oxide lens layer 342 may be provided such that the entire thickness thereof falls within the range of ±(1/8)λ1 or the range of ±(1/16)λ1 in the Z-axis direction from the middle between a node and an antinode adjacent thereto in the standing wave. The thickness of the oxide lens layer 342 may be, for example, (1/8)λ1 or less or may be (1/16)λ1 or less. By providing the oxide lens layer 342 at a different position from the nodes of the standing wave, the oxide lens layer 342 can properly guide photons. Also, by providing the oxide lens layer 342 at a different position from the antinodes of the standing wave, scattering of photons caused by the oxide lens layer 342 can be suppressed.

Each of the oxide lens layers 102, 104, 106, and 108 is preferably provided at a different position from the nodes or antinodes of the standing wave of a photon passing through the interior of the first reflecting mirror 10. In other words, each of the oxide lens layers 102, 104, 106, and 108 is preferably provided between a node and an antinode adjacent thereto in the standing wave of a photon. For example, each of the oxide lens layers 102, 104, 106, and 108 may be provided such that the entire thickness thereof falls within the range of ±(1/8)λ1 or the range of ±(1/16)λ1 in the Z-axis direction from the middle between a node and an antinode adjacent thereto in the standing wave. The thickness of each of the oxide lens layers 102, 104, 106, and 108 may be, for example, (1/8)λ1 or less or may be (1/16)λ1 or less.

By providing each of the oxide lens layers 102, 104, 106, and 108 at a different position from the nodes of the standing wave, the oxide lens layers 102, 104, 106, and 108 can properly guide photons into the waveguide C. Also, by providing each of the oxide lens layers 102, 104, 106, and 108 at a different position from the nodes of the standing wave, scattering of photons caused by the oxide lens layers 102, 104, 106, and 108 can be suppressed.

Referring back to Fig. 1, the operation of the single photon source device 1 according to the present embodiment will be described. When a voltage is applied between the positive electrodes 320 and 322 and the negative electrodes 324 and 326, electrons and holes are injected into the quantum dot 304 in the active layer 300. An electron and a hole that have been injected are recombined in the quantum dot 304, so that a photon is generated. The photon thus generated resonates inside the resonator 30 while the loss is prevented by the opening 344 of the oxide lens layer 342, and the photon enters the first reflecting mirror 10.

A photon P that has entered the first reflecting mirror 10 passes through the waveguide C in the first reflecting mirror 10 and is emitted above the first reflecting mirror 10. The photon P emitted from the first reflecting mirror 10 is coupled into an optical fiber, an optical waveguide, or the like, which is not illustrated, to be extracted to the outside.

In the single photon source device 1 according to the present embodiment, electrons and holes are injected into a quantum dot in the stacked structure 32, from the electrodes (positive electrodes 320 and 322 and negative electrodes 324 and 326) through the contact layers (upper contact layer 330 and lower contact layer 332). The paths for the electrons and holes do not include the reflecting mirrors (first reflecting mirror 10 and second reflecting mirror 20). Therefore, the resistance of the paths for the electrons and holes can be made lower without doping impurity ions into the reflecting mirrors and the like. As a result, absorption of generated photons by impurity ions can be suppressed, and the photons can be efficiently emitted to the outside.

With regard to the technologies described in Patent Literatures 1 to 3 mentioned above, the inventor has come to recognize the problem of needing to, in order to generate single photons in a quantum dot, inject electrons and holes only into the quantum dot. In the single photon source device 1 according to the present embodiment, the oxide confinement layers 310, 312, 314, and 316 are provided inside the hole guide layer 306 and the electron guide layer 308. The electrons and holes injected from the positive electrodes 320 and 322 and the negative electrodes 324 and 326 are suppressed from passing through the oxide confinement layers 310, 312, 314, and 316. Accordingly, the electrons and holes are injected only into the quantum dot 304 and are suppressed from being converted into photons in other regions. As a result, single photons can be efficiently generated from electrons and holes in the quantum dot 304.

Also, in the single photon source device 1 according to the present embodiment, the oxide confinement layers 310 and 312 form paths through which holes flow to the quantum dot 304, and the oxide confinement layers 314 and 316 form paths through which electrons flow to the quantum dot 304. This allows electrons and holes to be injected into the quantum dot 304 more certainly, enabling the electrons and holes to be efficiently converted into photons.

With regard to the technologies described in Patent Literatures 1 to 3 mentioned above, the inventor has also come to recognize the problem of needing to prevent the loss of single photons generated by a quantum dot in the resonator sandwiched between two reflecting mirrors. In the single photon source device 1 according to the present embodiment, since impurity doping is unnecessary for semiconductor layers other than the upper contact layer 330 and the lower contact layer 332 in the resonator 30, the absorption of photons by impurities can be suppressed. In addition, by arranging the upper contact layer 330 and the lower contact layer 332 at nodes of the standing wave of a photon, the absorption of photons by impurity ions contained in these contact layers can be suppressed. Also, by arranging the oxide confinement layers 310, 312, 314, and 316 at nodes of the standing wave of a photon, scattering of photons by the oxide confinement layers 310, 312, 314, and 316 can be suppressed. Furthermore, by allowing the oxide lens layer 342 to direct photons in a predetermined direction in the resonator 30, the loss of photons can be suppressed.

Although Fig. 1 shows a single quantum dot 304, when a quantum dot is prepared, multiple quantum dots may be generated. When electrons and holes are injected into multiple quantum dots, photons are generated by the multiple quantum dots, so that a single photon cannot be generated.

With the single photon source device 1 according to the present embodiment, electrons and holes are injected into a single quantum dot 304 with pinpoint accuracy by means of the oxide confinement layers 310, 312, 314, and 316, so that photons can be generated by the single quantum dot 304. As a result, the single photon source device 1 can be used as a single photon source. This single photon source can be used, for example, for photonic quantum computers.

The present embodiment describes an example in which the oxide confinement layers 310, 312, 314, and 316 are used to inject electrons and holes into the quantum dot 304. The application is not limited thereto and, instead of the oxide confinement layers, high-resistivity layers made of various materials having higher resistivity than the stacked structure 32 (specifically, the active layer 300 and the like) may be used. The high-resistivity layers may be made of various insulators, for example.

### Second Embodiment

The single photon source device according to the second embodiment differs from that of the first embodiment mainly in the configuration of the resonator. Therefore, the single photon source device according to the second embodiment may include, in addition to the resonator according to the second embodiment, configurations similar to the first reflecting mirror 10 and the second reflecting mirror 20 included in the single photon source device 1 according to the first embodiment.

Fig. 3 is a sectional view of a resonator 40 according to the second embodiment. Fig. 3 schematically shows nodes and antinodes of a standing wave of a photon, and the standing wave has the antinodes at the lower surface of the spacer layer 350, the quantum dot 304, and the upper surface of the spacer layer 340. The wavelength of the standing wave is A2. In Fig. 3, configurations similar to those in the single photon source device 1 according to the first embodiment will be denoted by the same reference characters, and the description thereof will be omitted as appropriate. The resonator 40 according to the second embodiment mainly includes a stacked structure 42, an upper contact layer 430, an oxide barrier layer 432, a lower contact layer 332, positive electrodes 320 and 322, negative electrodes 324 and 326, spacer layers 340 and 350, and an oxide lens layer 342.

The stacked structure 42 is constituted by stacked semiconductor layers. The stacked structure 42 includes an active layer 400 in which quantum dots 402 and 403 are formed, and buffer layers 410 and 420. The active layer 400 and buffer layers 410 and 420 may be mainly made of, for example, GaAs.

The buffer layer 410 is provided on the lower contact layer 332. The buffer layer 410 is doped with impurities and may be doped with Si, for example. The buffer layer 420 is provided on the active layer 400. The buffer layer 420 is doped with impurities and may be doped with C, for example.

The active layer 400 is provided on the buffer layer 410. The active layer 400 is not doped with impurities, and a potential barrier is created between the quantum dots 402, 403 and the buffer layer 410 and also between the quantum dots 402, 403 and the buffer layer 420. Each potential barrier has a thickness that allows an electron or a hole to pass through by tunneling effect. In the present embodiment, electrons and holes pass through the potential barriers by tunneling effect (more specifically, resonant tunneling effect) and are injected into the quantum dot 402.

Each of the quantum dots 402 and 403 generates a photon with a wavelength that resonates in the resonator 40 when an electron-hole pair having a specific potential difference is injected. Therefore, when an electron-hole pair having a potential difference different from the specific potential difference is injected, the quantum dots 402 and 403 do not generate a photon, or even if they do, the photon does not resonate in the resonator 40.

In the present embodiment, the quantum dot 402 is formed in the active layer 400 directly below a gap 436 in the oxide barrier layer 432, which will be described later. Also, the quantum dot 403 is formed in the active layer 400 directly below the oxide barrier layer 432. However, a quantum dot may only be formed in the active layer 400 directly below the gap 436.

The upper contact layer 430 is provided on the buffer layer 420. The upper contact layer 430 may be made of GaAs doped with C. On the upper contact layer 430, the positive electrodes 320 and 322 and the spacer layer 340 are provided. The upper contact layer 430 may be provided at or near a node of a standing wave of a photon. For example, the upper contact layer 430 may be provided such that the entire thickness thereof falls within the range of ±(1/8)λ2 or the range of ±(1/16)λ2 in the Z-axis direction from the node of the standing wave. The thickness of the upper contact layer 330 may be, for example, (1/4)λ2 or less or may be (1/8)λ2 or less. By providing the upper contact layer 430 at or near a node of the standing wave of a photon, the absorption of photons in the upper contact layer 430 can be suppressed.

The oxide barrier layer 432 is provided inside the upper contact layer 430 on the buffer layer 420. Inside the upper contact layer 430, the oxide barrier layer 432 is preferably provided at or near a node of the standing wave of a photon generated by the quantum dot 402. This can suppress the attenuation (scattering) of photons caused by the oxide barrier layer 432.

Even when the oxide barrier layer 432 is provided outside the upper contact layer 430, it is preferable that the oxide barrier layer 432 is provided at or near a node of the standing wave of a photon. In this case, for example, the oxide barrier layer 432 may be provided such that the entire thickness thereof falls within the range of ±(1/8)λ2 or the range of ±(1/16)λ2 in the Z-axis direction from the node of the standing wave. The thickness of the oxide barrier layer 432 may be, for example, (1/4)λ2 or less or may be (1/8)λ2 or less.

The oxide barrier layer 432 is a high-resistivity layer having higher resistivity than the upper contact layer 430 and the buffer layer 420. In specific, the oxide barrier layer 432 may be made of various oxides, which may include aluminum oxide, for example. The thickness of the oxide barrier layer 432 may be, for example, about 30 nm. The oxide barrier layer 432 according to the present embodiment has a rectangular shape in cross-sectional view of the resonator 40.

The oxide barrier layer 432 is provided such that the potential difference of an electron-hole pair injected into the quantum dot 403, which is different from the quantum dot 402 that should generate a photon that resonates in the resonator 40, differs from the specific potential difference. In specific, the oxide barrier layer 432 affects the potential difference of an electron-hole pair injected into the quantum dot 403 so that no photon is generated in the quantum dot 403 or a generated photon does not resonate in the resonator 40. Accordingly, photons are mainly generated only in the quantum dot 402.

In the oxide barrier layer 432 provided inside the upper contact layer 430, the gap 436 is formed. The upper contact layer 430 is connected with the buffer layer 420 at the opening of the gap 436. The gap 436 may suitably have a diameter of about 1 µm. With the gap 436 having a diameter of this size, photons can be generated only by the quantum dot 402 located directly below the gap 436 more certainly.

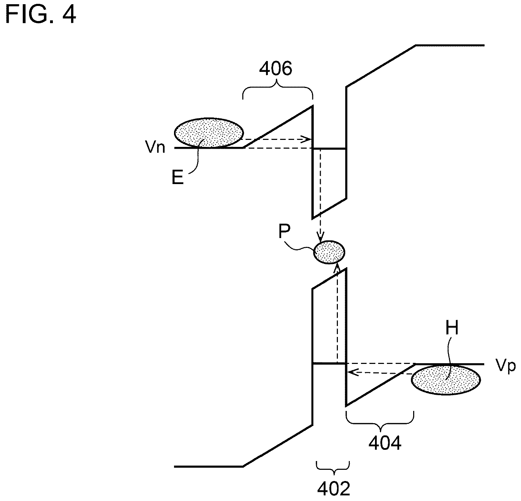

Fig. 4 is a diagram for illustrating a process by which a photon P is generated by combination of an electron E and a hole H in the present embodiment. Here, the process of generating a photon P in the quantum dot 402 located directly below the gap 436 in the oxide barrier layer 432 will be described.

When voltages are applied to the positive electrodes 320 and 322 and the negative electrodes 324 and 326, a hole H is given a voltage Vp supplied from the positive electrodes 320 and 322 to the upper contact layer 430, and an electron E is given Vn supplied from the negative electrodes 324 and 326 to the lower contact layer 332 as shown in Fig. 4.

The hole H passes through a potential barrier 404 present on the upper contact layer 430 side of the quantum dot 402 by tunneling effect and is injected into the quantum dot 402. Meanwhile, the electron E passes through a potential barrier 406 present on the lower contact layer 332 side of the quantum dot 402 by tunneling effect and is injected into the quantum dot 402. The electron E and hole H injected into the quantum dot 402 are combined, so that a photon P is generated. The wavelength of the photon P has a value corresponding to the difference ΔV (=Vp-Vn) between the potential Vn of the electron E and the potential Vp of the hole H. The photon P resonates in the resonator 40 and is output to the outside.

Although Fig. 3 shows a single quantum dot 402 directly below the gap 436, there may be multiple (e.g., about 10) quantum dots 402 directly below the gap 436. In this case, the multiple quantum dots 402 have variations in size and also in wavelength of photons they generate. When the potential difference ΔV between the injected electron E and hole H coincides with the wavelength of photons generated by a quantum dot 402, a photon P is generated in the quantum dot 402. In the other quantum dots 402, photons are not generated, or even if photons are generated, the photons do not resonate in the resonator 40. As a result, among about 10 quantum dots 402, for example, only a quantum dot 402 that generates a photon having a specific wavelength that coincides with the potential difference ΔV generates a photon P.

Meanwhile, in the quantum dot 403 located directly below the oxide barrier layer 432, the difference between the potential of the injected electron and the potential of the injected hole is affected. In specific, the oxide barrier layer 432 is provided such that the potential difference between the electron and hole injected into the quantum dot 403 is not a potential difference with which a photon can be generated in the quantum dot 403 or such that a photon generated with the potential difference between the electron and hole injected into the quantum dot 403 does not have a wavelength at which the photon resonates in the resonator 40.

For example, it is assumed here that the quantum dot 403 can generate a photon when an electron and a hole having the potential difference ΔV are injected. When the potential of a hole injected into the quantum dot 403 is affected by the electric field generated by the oxide barrier layer 432, the potential of the hole becomes Vp' (#Vp), and the potential difference between the electron and hole injected into the quantum dot 403 becomes ΔV' (≠ΔV). As a result, a quantum dot that resonates in the resonator 40 is not generated in the quantum dot 403. Thus, according to the present embodiment, a photon that resonates is not generated in the quantum dot 403 located directly below the oxide barrier layer 432 but can be generated only in the quantum dot 402 located directly below the gap 436 in the oxide barrier layer 432.

When the single photon source device according to an embodiment described above is used for a photonic quantum computer, a large number (e.g., one million or tens of millions) of single photon source devices are used. When used for a photonic quantum computer, all of these large number of single photon source devices need to generate photons having the same wavelength.

In the single photon source device according to an embodiment described above, the wavelengths of photons are aligned by resonating photons having a specific wavelength in the resonator 30 or 40. However, the resonant frequency of the resonator varies among devices, and even with a high Q value, the resonant frequency has a finite range. Therefore, in the resonator 40 according to the present embodiment, electrons and holes are injected into the quantum dot 402 by tunneling effect to generate photons having a specific wavelength. As a result, the wavelengths of the photons generated by each single photon source device can be aligned more precisely.

Also, in the present embodiment, photons can be mainly generated only in the quantum dot 402 located directly below the gap 436 in the oxide barrier layer 432. Therefore, generation of photons by an unintended quantum dot can be suppressed.

Also in the present embodiment, as in the first embodiment, the resistance of the paths for electrons and holes can be made lower without doping impurity ions into the reflecting mirrors and the like. As a result, absorption of generated photons by impurity ions is suppressed, and the photons can be efficiently emitted to the outside.

Although the present embodiment describes an example in which the oxide barrier layer 432 is provided in the upper contact layer 430, the oxide barrier layer may be provided at an arbitrary location in a range where it can affect the potential difference between the electron and hole injected into the quantum dot. For example, the oxide barrier layer may be provided in the lower contact layer 332 or the buffer layer 410 or 420. When the oxide barrier layer is provided in the lower contact layer 332, for example, it can affect the potential of the electron injected into the quantum dot.

### Supplement

The present invention has been described with reference to embodiments. The embodiments are intended to be illustrative only, and it will be obvious to those skilled in the art that various modifications to a combination of constituting elements or processes could be developed and that such modifications also fall within the scope of the present invention.

### INDUSTRIAL APPLICABILITY

The present invention is applicable to single photon source devices.

### REFERENCE SIGNS LIST

1 single photon source device, 10 first reflecting mirror, 20 second reflecting mirror, 30, 40 resonator, 32, 42 stacked structure, 100 DBR mirror, 102 oxide lens layer, 300, 400 active layer, 301 upper layer, 302, 410, 420 buffer layer, 303 lower layer, 304, 402, 403 quantum dot, 306 hole guide layer, 308 electron guide layer, 310, 312, 314, 316 oxide confinement layer, 320, 322 positive electrode, 324, 326 negative electrode, 330, 430 upper contact layer, 332 lower contact layer, 340 spacer layer, 342 oxide lens layer, 344 opening, 350 spacer layer, 432 oxide barrier layer, 436 gap, 404, 406 potential barrier, E, E1, E2 electron, H, H1 H2 hole, P photon

## Claims

1. A single photon source device, comprising:
a first reflecting mirror;
a second reflecting mirror; and
a resonator disposed between the first reflecting mirror and the second reflecting mirror,
the resonator comprising:
a stacked structure including a quantum dot that generates a photon corresponding to an electron and a hole injected thereinto;
an electrode from which an electron or a hole is injected into the quantum dot; and
a contact layer provided between the stacked structure and the electrode.

2. The single photon source device according to Claim 1,
wherein, when the electrode is a first electrode and the contact layer is a first contact layer, the resonator further comprises a second electrode from which an electron or a hole is injected into the quantum dot, and a second contact layer provided between the stacked structure and the second electrode,
wherein the stacked structure, the first contact layer, or the second contact layer includes a high-resistivity layer disposed therein,
wherein the first electrode is a positive electrode,
wherein the second electrode is a negative electrode,
wherein the first contact layer is connected to one end surface in a stacking direction of the stacked structure, and
wherein the second contact layer is connected to the other end surface in the stacking direction of the stacked structure.

3. The single photon source device according to Claim 2,
wherein the first contact layer and the second contact layer are each provided at or near a node of a standing wave of the photon.

4. The single photon source device according to Claim 2 or 3,
wherein, when the high-resistivity layer is a first high-resistivity layer, the stacked structure includes the first high-resistivity layer and a second high-resistivity layer each disposed therein,
wherein the first high-resistivity layer is provided to form a path for a hole flowing from the positive electrode to the quantum dot, and
wherein the second high-resistivity layer is provided to form a path for an electron flowing from the negative electrode to the quantum dot.

5. The single photon source device according to Claim 4,
wherein the first high-resistivity layer and the second high-resistivity layer are each provided at or near a node of a standing wave of the photon.

6. The single photon source device according to Claim 2 or 3,
wherein the quantum dot generates a photon that resonates in the resonator when an electron-hole pair having a specific potential difference is injected, and
wherein the high-resistivity layer is provided such that the potential difference of an electron-hole pair injected into a quantum dot, which is different from the quantum dot that should generate a photon that resonates in the resonator, differs from the specific potential difference.

7. The single photon source device according to Claim 6,
wherein an electron and a hole are injected into the quantum dot by tunneling effect.

8. The single photon source device according to Claim 6 or 7,
wherein the first contact layer or the second contact layer includes the high-resistivity layer.

9. The single photon source device according to any one of Claims 1 through 8,
wherein the resonator further comprises a photon guide layer that a photon generated by the quantum dot enters and that directs the photon that has entered in a predetermined direction.

10. The single photon source device according to Claim 9,
wherein the guide layer is constituted by an oxide layer with an opening formed therein, and a photon generated by the quantum dot enters the opening and is emitted in the predetermined direction, and
wherein the oxide layer is provided between a node and an antinode adjacent to the node in a standing wave of the photon.

11. The single photon source device according to any one of Claims 1 through 10,
wherein the first reflecting mirror is constituted by a multilayer film that includes waveguide forming layers forming a waveguide.
